**Europäisches Patentamt**

**European Patent Office**

**Office européen des brevets**

(19)

(11) Veröffentlichungsnummer : **0 033 749**
**B2**

(12) **NEUE EUROPÄISCHE PATENTSCHRIFT**

(45) Veröffentlichungstag der neuen Patentschrift :
**11.11.87**

(51) Int. Cl.⁴ : **G 01 L   9/06**

(21) Anmeldenummer : **80100603.2**

(22) Anmeldetag : **06.02.80**

(54) Piezoresistive zylinderdosenartige Druckmesszelle.

(43) Veröffentlichungstag der Anmeldung :
**19.08.81 Patentblatt 81/33**

(45) Bekanntmachung des Hinweises auf die Patenterteilung : **30.05.84 Patentblatt 84/22**

(45) Bekanntmachung des Hinweises auf die Entscheidung
über den Einspruch : **11.11.87 Patentblatt 87/46**

(84) Benannte Vertragsstaaten :
**AT BE CH DE FR GB IT LU NL SE**

(56) Entgegenhaltungen :
**AT-A-   316 894**
**DE-A- 2 630 640**
**DE-A- 2 809 549**
**GB-A- 1 540 716**
**US-A- 3 071 745**
**MESSEN + PRÜFEN/AUTOMATIK Februar 1974 H.W.**
**KELLER "Piezoresistive Druckaufnehmer" Seiten 89**
**bis 92**
**Regelungstechnische Praxis, 1977, Heft 6, Seiten**
**162-164**

(73) Patentinhaber : **Keller, Hans W. Dipl.-Phys.**
**St.-Galler-Strasse 106**
**CH-8404 Winterthur (CH)**

(72) Erfinder : **Keller, Hans W. Dipl.-Phys.**
**St.-Galler-Strasse 106**
**CH-8404 Winterthur (CH)**

(74) Vertreter : **Flach, Dieter Rolf Paul, Dipl.-Phys. et al**
**Patentanwälte Andrae/Flach/Haug/Kneissl Prinzre-**
**gentenstrasse 24**
**D-8200 Rosenheim (DE)**

## Beschreibung

Die Erfindung betrifft eine piezoresistive zylinderdosenartige Druckmesszelle nach dem Oberbegriff des Patentanspruches 1.

Ein derartiger Halbleiter-Druckwandler ist bereits aus der DE-A-2 809 549 bekanntgeworden, dessen Membran auf der Rückseite scheibenförmig ausgeschnitten ist, um eine Aussparung zu bilden. Ein ringförmiger Trägerteil ist stirnseitig an ein Gehäuse mittels eines Klebestoffes befestigt, wobei der Trägerteil dicker als der druckempfindliche Teil ist. Wie aus dieser Druckschrift aber hervorgeht, ist die Membran starr am Gehäuse befestigt. Diese starre Befestigung ist notwendig, da nur hierdurch ein definierter Auflagepunkt geschaffen werden kann, der zu möglichst klar definierten Messergebnissen führt. Eine bestimmte Empfindlichkeit und Genauigkeit des Druckwandlers lässt sich hiernach aber nicht weiter verbessern.

Eine Druckmesszelle ist auch aus der DE-A-2 630 640 mit einer vorderen stirnseitigen Zellenwand aus einer zumindest einen aufgeschichteten oder diffundierten Widerstand enthaltenden Messmembran bekanntgeworden. Die Rückseite der Messmembran ist ausgearbeitet, so dass die Messmembran in eine ringartige Zylinderhülse übergeht, wobei die Zylinderhülse über ihre Stirnfläche mittels eines Befestigungsmaterials hermetisch dicht auf der angrenzenden rückwärtigen kreisplattenförmigen Zellwand befestigt ist. Die Befestigung erfolgt hauptsächlich mittels eines Gold-Siliciumeutektikum-Lötprozesses oder mittels einer Verbindung mit niederschmelzendem Glaslot. Dieser Befestigungsvorgang ist sehr zeitaufwendig und teuer. Die zu verbindenden Flächen müssen genau plangeschliffen sein. Dadurch entsteht zwischen den zu verbindenden Teilen praktisch kein Spalt, in den normalerweise Lot beim Erhitzen durch Kapillarwirkung hineingezogen wird. Es ist daher erforderlich, während des Lötvorgangs oder während des Erhärtens des Epoxiharzes die zu verbindenden Teile mittels Ultraschall gegeneinander zu bewegen, um eine flächige Verbindung der Stirnfläche des Zylindermantels mit der rückwärtigen Zellwand herzustellen. Es kann auch noch erforderlich sein, wenn es sich um eine für Referenzmessungen einzusetzende Druckzelle handelt, bei welcher die rückwärtige Zellenwand einen Durchtritt zum Anschluss an ein Fluid mit Referenzdruck aufweist, den Innenraum der Druckmesszelle während des Verlötens oder des Erhärtens des Epoxiharzes zu evakuieren, damit das Befestigungsmaterial besser von aussen nach innen eingezogen wird. Erschwert wird dieser Vorgang auch noch dadurch, dass nach durchgeführter Verbindung die Teile spannungsfrei abgekühlt werden müssen, um eine Grunddeformation der Messmembran zu vermeiden, da dies zu einem von vornherein eingeprägten Körperfremdsignal führen würde. Sind alle Arbeitsvorgänge in einwandfreier Weise durchgeführt, so erhält man eine hochwertige, weitgehend hysteresefreie Druckmesszelle, die auch für relativ hohe Drücke oder Druckdifferenzen (z. B. 0,1 bis 1 000 bar) anwendbar ist und Messergebnisse von relativ hoher Genauigkeit bei weitgehender Invarianz gegenüber Temperatureinflüssen liefert.

Für viele Anwendungszwecke, beispielsweise für elektronische Sphygmomanometer (nicht invasive Blutdruckmesser), für Messungen an Vergasern von Brennkraftmaschinen und dergleichen, sind Drücke zu messen, die nur relativ wenig oberhalb oder unterhalb des normalen Atmosphärendruckes liegen (bis herunter zu etwa ± 0,5 bar), wobei darüber hinaus keine sehr hohen Messgenauigkeiten erforderlich sind.

Demgegenüber ist es Aufgabe der Erfindung, eine technisch entsprechend einfache und billig herstellbare Druckmesszelle mit verbesserten Messeigenschaften zu schaffen. Die Aufgabe wird erfindungsgemäss entsprechend den im kennzeichnenden Teil des Anspruchs 1 angegebenen Merkmalen gelöst.

Durch die elastische Verbindung der Stirnfläche der Zylinderhülse mit der rückwärtigen kreisplattenförmigen Zellenwand, die vorzugsweise aus einem von der Messmembran verschiedenen Material besteht, wird erreicht, dass trotz des einfachen Befestigungsvorganges nach dem Erhärten des Kunststoffes nur sehr geringe Deformationskräfte auf die Messmembran übertragen werden, so dass ein Basiswert eines Körperfremdsignals als Folge einer bestehenden Anfangsdeformation sehr gering bleibt. Bei Druckbeaufschlagung der vorderen stirnseitigen Zellenwand von aussen wird diese etwa kalottenartig eingebeult, wobei gleichzeitig die ringartige Zylinderhülse zu einem Kegelmantel deformiert wird. Hierbei wird der die Stirnfläche der Zylinderhülse mit der rückwärtigen kreisplattenförmigen Zellenwand verbindende elastische Kunststoff auf Dehnung beansprucht. Bei schwankenden Temperaturen und unterschiedlichen radialen Ausdehnungen der Messmembran und dem zufolge der rückwärtigen Zellenwand wird der elastische Kunststoff auf Scherung beansprucht, wobei aber wesentliche Einbeulungen der Messmembran und damit grössere Körperfremdsignale vermieden werden. Die rückwärtige Zellenwand kann z. B. aus einer Glasplatte mit Durchführungsdrähten bestehen, mit denen die Zuleitungen der Messmembran kontaktiert sind, oder auch aus einer Aluminiumsubstratplatte einer elektrischen Hybridschaltung, mit denen die Zuleitungen der Messmembran unmittelbar kontaktiert sind. Auch die Verwendung einer normalen Leiterplatte anstelle einer Aluminiumsubstratplatte ist möglich.

Durch die Weiterbildungen nach den Patentansprüchen 2 bis 4 ergeben sich besonders günstige Ausbildungsformen des Befestigungsmaterials für verschiedene Anwendungszwecke. Besonders vorteilhaft sind die angegebenen Ausführungsformen des Befestigungsmaterials insbesondere wegen geringer Hysterese. Dies ist besonders wesentlich, wenn schnell wechselnde Drücke zu messen sind.

Durch die Weiterbildung nach dem Patentanspruch 4 wird eine besonders preisgünstige Herstellung der Druckmesszelle erzielt.

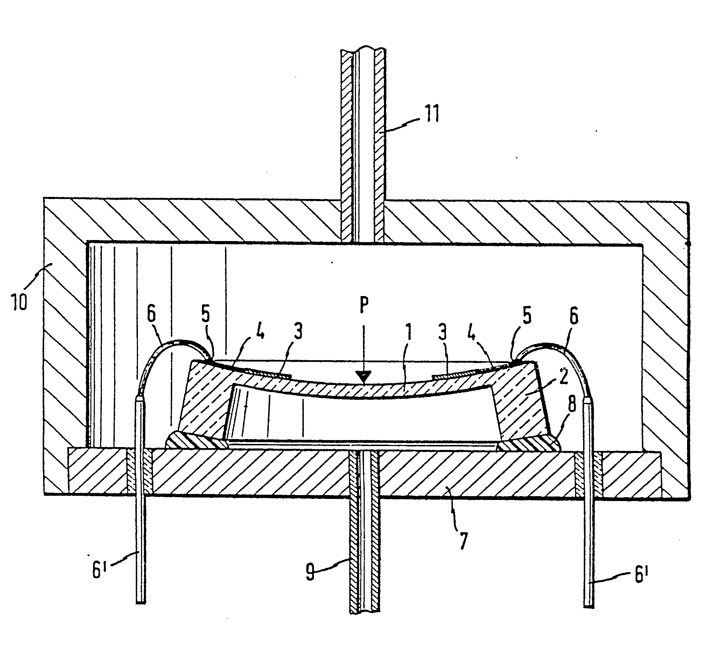

Die Erfindung ist nachstehend anhand der Zeichnung näher erläutert, welche ein Ausführungsbeispiel einer erfindungsgemässen Druckmesszelle bei Druckbeanspruchung von aussen her im Axialschnitt zeigt.

Die in der Zeichnung veranschaulichte Druckmesszelle besteht aus einer eine Messmembran 1 bildenden vorderen stirnseitigen Zellenwand, beispielsweise aus n-dotiertem Silizium, deren Rückseite in eine ringartige Zylinder- oder Polygonhülse 2 übergeht. Auf der äusseren Oberfläche der Zellenwand 1 sind diffundierte oder aufgeschichtete p-Typ-Widerstände 3 angeordnet, die über Schichtleitungen 4 und Kontaktpunkte 5 mit je einer Zuleitung 6 verbunden sind. Die Art der Anbringung der Widerstände 3 und der Kontaktierung ist Stand der Technik.

Die rückwärtige (in der Zeichnung untere) Stirnfläche der Zylindermantels ist auf eine aus Metall bestehende rückwärtige kreisplattenförmige Zellenwand 7 mittels eines elastischen, auf Dehnung und Scherung zu beanspruchenden Kunststoffes 8 geklebt. Sollen Absolutdruckmessungen durchgeführt werden, so ist die rückwärtige Zellenwand 7 geschlossen, sollen Referenzdruckmessungen durchgeführt werden, so ist das Zentrum der Zellenwand 7 von einem Loch oder Durchführungsrohr 9 durchsetzt. Die Zellenwand 7 weist gasdicht in Glas eingeschmolzene Durchführungsdrähte 6′ auf, mit denen die Zuleitungen 6 kontaktiert sind. Auf der Zellenwand 7 ist gasdicht ein Gehäuse 10 mit einem Zuleitungsrohr 11 montiert, durch welche die Druckmesszelle mit einem Druck P zu beaufschlagen ist.

Die Druckmesszelle ist in der Zeichnung unter der Einwirkung des Druckes P veranschaulicht, d. h. in einem deformierten Zustand (stark übertrieben dargestellt), wobei die vordere Zellenwand 1 kalottenartig durchgedrückt und die Zylinderhülse zu einem Kegelstumpf deformiert sind. Die Schicht des Befestigungsmaterials 8 ist keilförmig deformiert.

Es versteht sich, dass im unbelasteten Zustand die vordere stirnseitige Zellenwand 1 planeben ist, dass die Zylinderhülse entsprechend ihrer Bezeichnung eine zylindrische Form aufweist und dass die Schicht des Kunststoffes 8 einen rechteckigen anstatt keilförmigen Querschnitt aufweist.

Die Anordnung kann auch so getroffen sein, dass das Gehäuse 10 geschlossen ist, also das Zuleitungsrohr 11 nicht vorgesehen ist. Die Druckbeaufschlagung erfolgt dann von innen her über das Durchführungsrohr 9 (Absolutdruckmessung).

**Patentansprüche**

1. Piezoresistive zylinderdosenartige Druckmesszelle mit einer vorderen stirnseitigen Zellenwand aus einer zumindest einen aufgeschichteten oder diffundierten Widerstand (3) enthaltenden Messmembran (1), deren Rückseite in eine ringartige Zylinder- oder Polygonhülse (2) übergeht, deren Dicke, d. h. Höhe grösser ist als die Dicke der Messmembran (1), und mit einer rückwärtigen kreisplatten- oder polygonförmigen Zellenwand (7), auf der Zylinder- oder Polygonhülse (2) mit ihrer Stirnfläche mittels eines Befestigungsmaterials (8) hermetisch dicht befestigt ist, wobei die rückwärtige Zellenwand (7) vorzugsweise aus einem von der Messmembran (1) verschiedenen Material besteht, dadurch gekennzeichnet, dass das Befestigungsmaterial (8) aus einem auf gummielastische Dehnung und Scherung zu beanspruchenden Kunststoff besteht und dass die Dicke der Messmembran (1) höchstens 1/4, vorzugsweise aber höchstens 1/20 der Dicke, d. h. Höhe der Zylinder- oder Polygonhülse (2) ausmacht.

2. Druckmesszelle nach Anspruch 1, dadurch gekennzeichnet, dass das Befestigungsmaterial (8) aus Silikonkautschuk besteht.

3. Druckmesszelle nach Anspruch 2, dadurch gekennzeichnet, dass das Befestigungsmaterial (8) aus 70 % Silikonöl und bis zu 30 % aus Härter besteht und einen Shore-Härte von 35⁻, einen Elastizitätsmodul von 40 N/cm² bei 150 % Längenänderung und eine Elongation vor Bruch von 300 % aufweist.

4. Druckmesszelle nach Anspruch 1, dadurch gekennzeichnet, dass die rückwärtige Zellenwand (7) aus Glas, Leiterplattenmaterial oder Metall, z. B. Aluminiumsubstrat besteht.

**Claims**

1. A piezoresistive pressure measuring sensor cell comprising a front end cell wall made up of a precision diaphragm (1) having at least one laminated or diffused resistor (3), the back side of said precision diaphragm (1) joining with a ring-like cylindrical or polygonal sleeve (2), whose thickness, i. e. height is greater than the thickness of the precision diaphragm (1), and with a back cell wall (7) in the form of a polygon or a round plate, said cylindrical or polygonal sleeve (2) having its end face fixed on the cell wall (7) hermetically by a bonding material (8), the back cell wall (7) preferably being made of a material other than the material of the precision diaphragm (1), characterized in that the bonding material (8) is made of a synthetic resin to be acted upon by rubber-elastic stretching and shear forces and in that the thickness of the precision diaphragm (1) is at the most 1/4 or more specially at the most 1/20 of the thickness, i. e. height of the cylindrical or polygonal sleeve (2).

2. The pressure gage cell as claimed in claim 1, characterized in that the bonding material (8) is made up of silicone rubber.

3. The pressure gage cell as claimed in claim 2, characterized in that the said bonding material (8) is made up of 70 % of silicone oil and up to 30 % of curing agent and has a Shore hardness of 35⁻, an elastic moduls of 40 N/cm² at an elongation of 150 % and an ultimate elongation of 300 %.

4. The pressure gage cell as claimed in claim 1, characterized in that the back cell wall (7) is made of glass, PCB material or metal as for example aluminum base.

**Revendications**

1. Cellule de mesure de la pression piézorésistive en forme de boîte cylindrique comprenant une paroi cellulaire frontale avant composée d'une membrane de mesure (1) contenant au moins une résistance (3) diffusée ou déposée en forme de couche, la face arrière de la membrane se transformant en un manchon cylindrique ou polygonal annulaire (2) dont l'épaisseur, c'est-à-dire hauteur est plus grande que celle de la membrane de mesure (1) ; ainsi qu'une paroi cellulaire arrière (7), polygonale ou en forme de plaque circulaire, sur laquelle le manchon cylindrique ou polygonal (2) est fixé d'une manière étanche et hermétique, par sa surface frontale, au moyen d'un matériau de fixation (8), la paroi cellulaire arrière (7) se composant de préférence d'une matière différente de celle de la membrane de mesure (1), caractérisée en ce que le matériau de fixation (8) est constitué d'une matière synthétique élastique à solliciter à la dilatation et au cisaillement et en ce que l'épaisseur de la membrane de mesure (1) représente au maximum le quart, mais de préférence au maximum le vingtième de l'épaisseur, c'est-à-dire hauteur du manchon cylindrique ou polygonal (2).

2. Cellule de mesure de pression selon la revendication 1, caractérisée en ce que le matériau de fixation (8) est un caoutchouc à la silicone.

3. Cellule de mesure de pression selon la revendication 2, caractérisée en ce que le matériau de fixation (8) se compose de 70 % d'huile de silicone et de 30 % au maximum de durcisseur et a une dureté Shore de 35⁻, un module élasticité de 40 N/cm² pour une déformation linéaire de 150 % et un allongement à la rupture de 300 %.

4. Cellule de mesure de pression selon la revendication 1, caractérisée en ce que la paroi cellulaire arrière (7) se compose de verre, d'une plaquette de circuits imprimés ou de métal, par exemple, un substrat d'aluminium.